# EUROPÄISCHE PATENTANMELDUNG

(11) **EP 2 605 028 A1**
(43) Veröffentlichungstag der Anmeldung: **19.06.2013**
(21) Anmeldenummer: 12185017.6
(22) Anmeldetag: 19.09.2012
(51) Int. Cl.: G01R 31/36, H01M 10/48

(54) **Vorrichtung zur Spannungsüberwachung von Batteriezellen**

(30) Priorität: 13.12.2011 EP 11193187
(71) Anmelder: Magna E-Car Systems GmbH & Co OG, 8041 Graz (AT)
(72) Erfinder: Geidl, Uwe, 8101 Gratkorn (AT); Stark, Johann, 8302 Nestelbach/Graz (AT)
(74) Vertreter: Rausch, Gabriele

(57) **Zusammenfassung**

Eine Vorrichtung zur Spannungsüberwachung von Batteriezellen, umfassend ein Steuergerät (4), Spannungsabgriffe (2) zum Abgriff der Spannungen der Batteriezellen und Messleitungen (3) zur elektrischen Verbindung des Steuergeräts (4) mit den Spannungsabgriffen (2), wobei die Messleitungen (3) in eine Halteplatte (1) integriert sind, die Spannungsabgriffe (2) und das Steuergerät (4) an der Halteplatte (1) angeordnet sind und das Steuergerät (4) mittels Steckverbindungen (5) mit steuergerätseitigen Enden der Messleitungen (3) direkt verbunden ist.

## Beschreibung

### Gebiet der Erfindung

Die vorliegende Erfindung betrifft eine Vorrichtung zur Spannungsüberwachung von Batteriezellen, insbesondere eine Vorrichtung zur Spannungsüberwachung von Batteriezellen umfassend ein Steuergerät, Spannungsabgriffe zum Abgriff der Spannungen der Batteriezellen und Messleitungen zur elektrischen Verbindung des Steuergeräts mit den Spannungsabgriffen.

Insbesondere Hochvolt-Batteriesysteme die aus einer Vielzahl von beispielsweise Li-Ion-Zellen aufgebaut sind, verfügen üblicherweise über eine Überwachung der Spannung der einzelnen Batteriezellen und bevorzugt auch eine Einrichtung zum Abgleich der Spannungen der Batteriezellen untereinander ("Load-Balancing"). Der Abgriff der Zellspannungen erfolgt entweder direkt an Zellpolen oder auch an Zellverbindern.

### Stand der Technik

Aus der DE 198 47 190 A1 ist beispielsweise eine Verbindungsplatte für einen Batteriehalter bekannt, die als gespritzte Harzplatte ausgeführt ist, mit eingegossenen Stromschienen und mit Spannungsmessanschlüssen und Drähten für das Messen der Spannungen von Batterien. Durch das Eingießen ist die Lage der Stromschienen festgelegt. Die Drähte werden aus der Verbindungsplatte herausgeführt und können zu einer zu verbindenden ECU (Electronic Control Unit) führen.

Weiters ist es aus der US 2011/0045329 A1 bekannt, Anschlussstücke zu verwenden, wobei jeweils ein Ende eines Anschlussstückes mit einer Stromschiene verbindbar ist und das zweite Ende über Scherenabschnitte mit einem Draht verbindbar ist, wobei die Drähte wiederum mit einem Spannungsmessgerät verbindbar sind.

Aus der DE 10 2009 050 315 A1 ist eine Verbindungsvorrichtung bekannt zum elektrisch leitenden Verbinden mehrerer Zellterminals von Zellen. Die Vorrichtung weist (in Fig. 38) Leiterbahnen auf, die einstückig mit Zellverbindern verbunden sind. Die Zellverbinder sind an einem Hilfsrahmen gehalten, der auch die Leiterbahnen abstützt. Die den Zellverbindern abgewandten freien Enden der Leiterbahnen sind elektrisch leitend mit einem Verbindungssteg verbunden, welcher durch einen Stecker einer Kabelverbindung ersetzbar ist, die zu einer Steuereinheit führt.

Besonders in der Großserien-Fertigung von Batteriesystemen ist die Herstellung von derartigen Vorrichtungen zur Spannungsüberwachung von Batteriezellen fehleranfällig und kostenintensiv, da für jedes Batteriesystem mit vielen Batteriezellen eine große Anzahl von meist freiliegenden Messleitungen prozesssicher gehandhabt werden muss und insbesondere die Messleitungen jeweils mit den zugehörenden Anschlüssen des Steuergeräts und den zugehörenden Spannungsabgriffen der Batteriezellen verbunden werden müssen. Es kann leicht geschehen, dass bei der Fertigung zwei Messleitungen miteinander vertauscht werden und so beispielsweise eine kostenintensive Nachbearbeitung erforderlich wird.

### Zusammenfassung der Erfindung

Es ist daher eine Aufgabe der Erfindung eine Vorrichtung zur Spannungsüberwachung von Batteriezellen anzugeben, die einfach, mit geringen Kosten und geringer Fehleranfälligkeit fertigbar ist und bei der insbesondere das Risiko von falschen Leitungszuordnungen minimiert ist.

Die Lösung der Aufgabe erfolgt durch eine Vorrichtung zur Spannungsüberwachung von Batteriezellen, umfassend ein Steuergerät, Spannungsabgriffe zum Abgriff der Spannungen der Batteriezellen und Messleitungen zur elektrischen Verbindung des Steuergeräts mit den Spannungsabgriffen, wobei die Messleitungen in eine Halteplatte integriert sind, die Spannungsabgriffe und das Steuergerät an der Halteplatte angeordnet sind und das Steuergerät mittels Steckverbindungen mit steuergerätseitigen Enden der Messleitungen direkt verbunden ist.

Erfindungsgemäß ist das Steuergerät unmittelbar an der Halteplatte angeordnet. Die Messleitungen verlaufen im Wesentlichen innerhalb der Halteplatte oder zumindest auf der Halteplatte derart integriert, dass die Lage der Messleitungen bis zu deren Enden, die mit dem Steuergerät verbindbar sind, durch die Halteplatte festgelegt ist. An der selben Halteplatte sind auch die Spannungsabgriffe, beispielsweise Zellpole oder Zellverbinder, angeordnet. Bevorzugt sind auch die Positionen der Spannungsabgriffe durch die Halteplatte festgelegt. Beispielsweise können Zellverbinder in der Halteplatte durch eine Clip-Verbindung befestigbar sein. Das Steuergerät wird über eine Steckverbindung direkt an der Halteplatte befestigt und weist dazu jeweils erste Teile von Steckverbindungen auf, die mit den Enden der Messleitungen verbindbar sind.

Weiterbildungen der Erfindung sind in den abhängigen Ansprüchen, der Beschreibung sowie den beigefügten Zeichnungen angegeben.

Bevorzugt sind die Steckverbindungen als Press-Fit-Verbindungen ausgeführt. Dadurch ist eine auch in Großserienfertigung leicht herstellbare und zuverlässige Verbindung der Anschlüsse des Steuergerätes an der Halteplatte gewährleistet.

Vorzugsweise ist jeweils ein Gehäuseteil der Steckverbindungen durch die Halteplatte ausgebildet. Die Halteplatte selbst bildet daher jeweils Abschnitte aus, die für die Steckverbindung erforderlich sind und bildet daher einen Teil der Steckverbindung. Beispielsweise können Buchsen der Steckverbindung im Wesentlichen durch die Halteplatte ausgebildet sein.

Bevorzugt weisen die steuergerätseitigen Enden der Messleitungen jeweils ein Loch zur Aufnahme von Steckern der Steckverbindungen auf. Die Stecker, die bevorzugt am Steuergerät ausgebildet sind, können dann beispielsweise so in der Halteplatte angesteckt sein, dass sie von der Halteplatte gestützt werden und durch das Loch der jeweiligen Messleitung hindurchreichen, um stabil fixiert und mit der Messleitung elektrisch leitend verbunden zu sein.

Besonders bevorzugt weist das Steuergerät Pins als Stecker der Steckverbindungen auf. Buchsen der Steckverbindungen sind dann an der Halteplatte, im Bereich der steuergerätseitigen Enden der Messleitungen ausgebildet.

Gemäß einer Ausgestaltung der Erfindung sind die steuergerätseitigen Enden der Messleitungen als Stecker der Steckverbindungen ausgebildet und am Steuergerät die Buchsen der Steckverbindungen ausgebildet. Besonders bevorzugt enden alle steuergerätseitigen Enden der Messleitungen in einer gemeinsamen Steckverbindungsebene, die normal zur Halteplatte steht. Dabei könnten in vertikaler Richtung auch mehrere Schichten von Enden der Messleitungen angeordnet sein, zum Anschluss beispielsweise einer zweireihigen oder mehrreihigen Steckerbuchse. Gemäß einer weiteren Ausführungsform sind Schnittstellenleitungen zur Verbindung des Steuergeräts mit einer externen Schnittstelle in der Halteplatte integriert. Eine externe Schnittstelle, beispielsweise zur Anbindung einer weiteren Elektronikeinheit, wird so platzsparend über Schnittstellenleitungen angesprochen, die in der Halteplatte oder zumindest fest verbunden an der Halteplatte angeordnet sind.

Bevorzugt ist die externe Schnittstelle als eine an der Halteplatte angeordnete weitere Steckverbindung ausgeführt. Externe Komponenten können so ebenfalls komfortabel und sicher mit einer erfindungsgemäßen Halteplatte elektrisch verbunden werden.

### Kurzbeschreibung der Zeichnung

Die Erfindung wird im Folgenden beispielhaft unter Bezugnahme auf die Zeichnungen beschrieben.
- Fig. 1: ist eine schematische Darstellung einer erfindungsgemäßen Vorrichtung in Draufsicht.
- Fig. 2: ist eine schematische Darstellung einer Steckverbindung einer erfindungsgemäßen Vorrichtung in Seitenansicht.
- Fig. 3: ist eine schematische Darstellung gem. Fig. 2 mit einem Steuergerät.
- Fig. 4: ist eine schematische Darstellung einer weiteren Steckverbindung einer erfindungsgemäßen Vorrichtung in Seitenansicht.
- Fig. 5: ist eine schematische Darstellung gem. Fig. 4 mit einem Steuergerät.

### Detaillierte Beschreibung der Erfindung

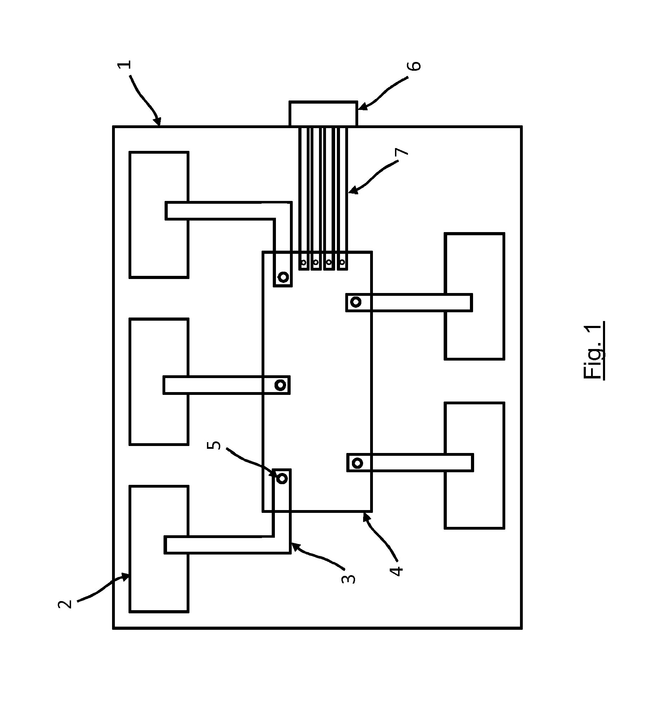

In Fig. 1 ist eine erfindungsgemäße Vorrichtung zur Spannungsüberwachung von Batteriezellen dargestellt, mit einer Halteplatte 1, die als Abdeckplatte eines Batteriesystems ausgeführt ist. Das Batteriesystem umfasst eine Vielzahl von hier nicht dargestellten beispielsweise prismatischen Batteriezellen, die durch eine Spannvorrichtung zusammengespannt sein können. Auf der Oberseite des Batteriesystems ist die Halteplatte 1, mit darin eingelegten, beispielsweise mittels Clip-Verbindungselementen gehaltenen oder umspritzten Spannungsabgriffen 2 angeordnet. Die Spannungsabgriffe 2 sind Zellverbinder, zur paarweisen Verbindung von Zellpolen benachbarter Batteriezellen. In der Halteplatte 1 integriert verlaufen Messleitungen 3, die bevorzugt als flache Leiterbahnen ausgeführt sind. Ein Ende jeder Messleitung 3 ist mit einem Spannungsabgriff 2 so verbunden, dass die Verbindung einen möglichst geringen elektrischen Übergangswiderstand aufweist, beispielsweise durch eine stoffschlüssige Verbindung wie Schweißen. Das andere, steuergerätseitige Ende jeder Messleitung 3 weist eine Hälfte einer Press-Fit Verbindung auf, nämlich ein Loch mit einer geeigneten Oberflächenbeschichtung im Bereich des Lochs zum Schutz der Oberfläche. Ein Steuergerät 4 weist die andere Hälfte der Press-Fit-Verbindung auf, beispielsweise in Form von Pins. Bei der Befestigung des Steuergeräts 4 auf der Halteplatte 1 werden die Zellspannungs-Signal-Eingänge des Steuergeräts 4 leitend mit den Messleitungen 3 verbunden.

Weiters weist die Halteplatte 1 Schnittstellenleitungen 7 auf, die ebenfalls in der Halteplatte 1 oder zumindest lagefixiert an der Halteplatte 1 angeordnet sind, zur Anbindung einer externen Schnittstelle 6 an das Steuergerät 4. Die externe Schnittstelle 6 ist als weitere Steckverbindung an einem Rand der Halteplatte 1 ausgeführt und dient dem Anschluss einer weiteren Elektronikeinheit. Selbstverständlich kann eine erfindungsgemäße Vorrichtung auch mehrere externe Schnittstellen 6 zur Verfügung stellen.

Durch die Geometrie des Steuergeräts 4 und die daran ausgebildeten Hälften der Steckverbindungen 5 im Zusammenspiel mit den fix positionierten zweiten Hälften der Steckverbindungen 5 an der Halteplatte 1 und den in der Halteplatte 1 festgelegten Zellverbindern kann eine falsche Leitungszuordnung ausgeschlossen werden. Die erfindungsgemäße Vorrichtung eignet sich besonders zur Fertigung von Batteriesystemen in hoher Stückzahl.

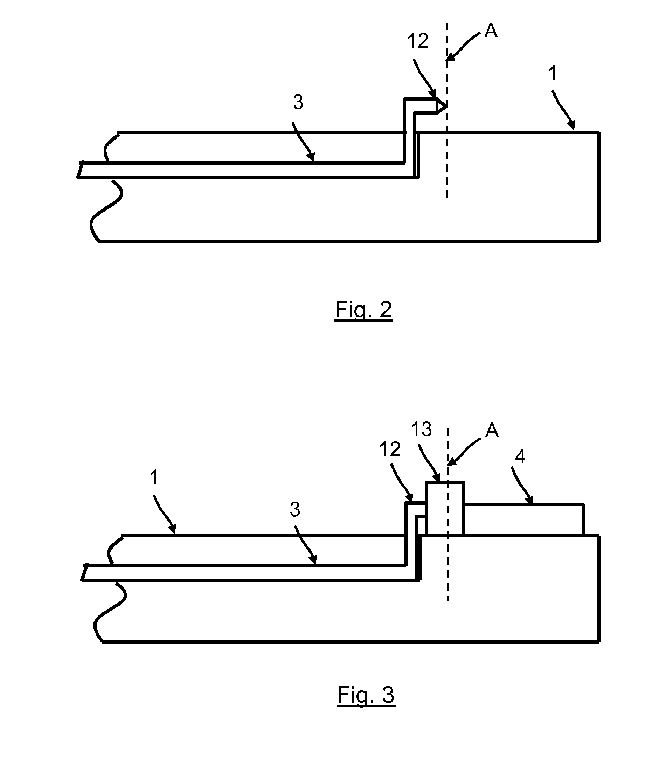

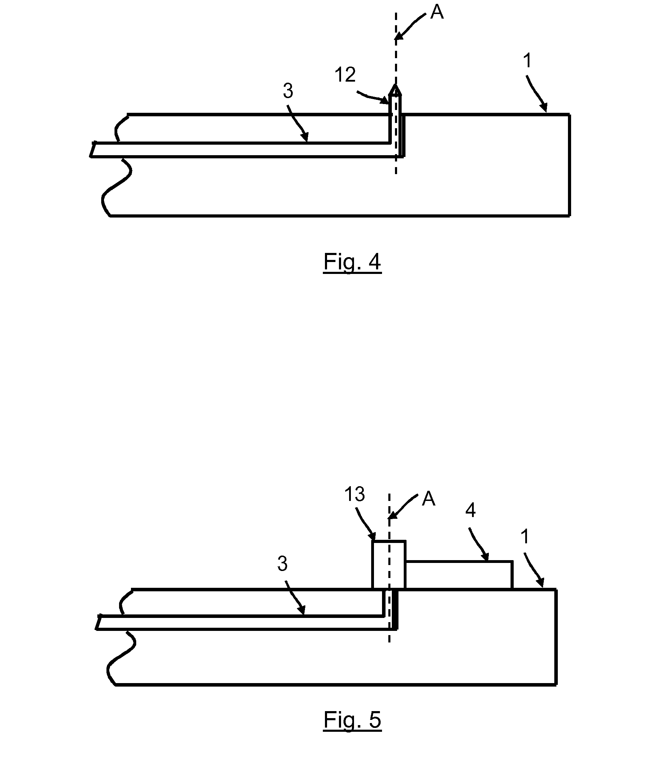

In den Fig. 2 bis Fig. 5 sind die Bereiche der Steckverbindungen 5 einer erfindungsgemäßen Vorrichtung in einer Seitenansicht dargestellt, wobei jeweils die steuergerätseitigen Enden der Messleitungen 3 als Stecker der Steckverbindungen 5 ausgebildet sind und am Steuergerät 4 die Buchsen der Steckverbindungen 5 ausgebildet sind. In den Fig. 2 und Fig. 4 sind die Enden der Messleitungen 3 ohne angestecktes Steuergerät 4 gut ersichtlich, in den Fig. 3 und Fig. 5 sind jeweils die selben Ausführungen der Fig. 2 und Fig. 4 mit angestecktem Steuergerät 4 dargestellt.

Die Enden der Messleitungen 3 können, wie in Fig. 2 dargestellt, aus der Halteplatte vertikal herausgeführt sein und danach parallel zur Halteplatte geführt sein. Die Messleitungen 3 enden jeweils in einer gemeinsamen Steckverbindungsebene A die normal auf die Halteplatte 1 steht. Die Enden der Messleitungen 4 bilden jeweils einen Steckabschnitt 12 aus. Das Steuergerät 4 bildet einen zugehörigen steuergerätseitigen Steckabschnitt 13 aus, der die Buchsen der Steckverbindung 5 bildet.

Die Enden der Messleitungen 3 können auch vertikal aus der Halteplatte 1 hervorstehen, wie in Fig. 4 und Fig. 5 dargestellt. Das Steuergerät 4 mit dessen Steckabschnitt 13 wird dann von oben auf die Halteplatte 1 und auf die Steckabschnitte 12 der Messleitungen 3 aufgesteckt.

### Bezugszeichenliste

- 1: Halteplatte
- 2: Spannungsabgriff
- 3: Messleitung
- 4: Steuergerät
- 5: Steckverbindung
- 6: externe Schnittstelle
- 7: Schnittstellenleitung

- 12: Steckabschnitt Messleitung
- 13: Steckabschnitt Steuergerät

- A: Steckverbindungsebene

## Patentansprüche

1. Vorrichtung zur Spannungsüberwachung von Batteriezellen, umfassend ein Steuergerät (4), Spannungsabgriffe (2) zum Abgriff der Spannungen der Batteriezellen und Messleitungen (3) zur elektrischen Verbindung des Steuergeräts (4) mit den Spannungsabgriffen (2),
**dadurch gekennzeichnet, dass** die Messleitungen (3) in eine Halteplatte (1) integriert sind, die Spannungsabgriffe (2) und das Steuergerät (4) an der Halteplatte (1) angeordnet sind und das Steuergerät (4) mittels Steckverbindungen (5) mit steuergerätseitigen Enden der Messleitungen (3) direkt verbunden ist.

2. Vorrichtung nach Anspruch 1,
**dadurch gekennzeichnet, dass** die Steckverbindungen (5) als Press-Fit-Verbindungen ausgeführt sind.

3. Vorrichtung nach Anspruch 1 oder 2,
**dadurch gekennzeichnet, dass** jeweils ein Gehäuseteil der Steckverbindungen (5) durch die Halteplatte (1) ausgebildet ist.

4. Vorrichtung nach zumindest einem der vorhergehenden Ansprüche,
**dadurch gekennzeichnet, dass** die steuergerätseitigen Enden der Messleitungen (3) jeweils ein Loch zur Aufnahme von Steckern der Steckverbindungen (5) aufweisen.

5. Vorrichtung nach zumindest einem der vorhergehenden Ansprüche,
**dadurch gekennzeichnet ,dass** das Steuergerät (4) Pins als Stecker der Steckverbindungen (5) aufweist.

6. Vorrichtung nach zumindest einem der Ansprüche 1 bis 3,
**dadurch gekennzeichnet, dass** die steuergerätseitigen Enden der Messleitungen (3) als Stecker der Steckverbindungen (5) ausgebildet sind und am Steuergerät (4) Buchsen der Steckverbindungen (5) ausgebildet sind.

7. Vorrichtung nach zumindest einem der vorhergehenden Ansprüche,
**dadurch gekennzeichnet, dass** Schnittstellenleitungen (7) zur Verbindung des Steuergeräts (4) mit einer externen Schnittstelle (6) in der Halteplatte (1) integriert sind.

8. Vorrichtung nach Anspruch 7,
**dadurch gekennzeichnet , dass** die externe Schnittstelle (6) als eine an der Halteplatte (1) angeordnete weitere Steckverbindung ausgeführt ist.
